# EUROPÄISCHE PATENTSCHRIFT

(11) **EP 3 170 260 B1**
(45) Veröffentlichungstag und Bekanntmachung des Hinweises auf die Patenterteilung: **27.12.2017**
(21) Anmeldenummer: 14747858.0
(22) Anmeldetag: 16.07.2014
(51) Int. Cl.: H03K 17/972, H01H 9/04

(54) **FELDGERÄT MIT EINER EINGABEEINHEIT**
FIELD DEVICE WITH AN INPUT UNIT
APPAREIL DE TERRAIN ÉQUIPÉ D'UNE UNITÉ D'ENTRÉE

(43) Veröffentlichungstag der Anmeldung: 24.05.2017
(73) Patentinhaber: VEGA Grieshaber KG, 77709 Wolfach (DE)
(72) Erfinder: ALLGAIER, Volker, 77716 Haslach (DE); FEHRENBACH, Josef, 77716 Haslach (DE); STAIGER, Holger, Hardt 78739 (DE); BÖRSIG, Jörg, Schapbach 77776 (DE)
(74) Vertreter: Westphal, Mussgnug & Partner Patentanwälte mbB
(86) Internationale Anmeldenummer: PCT/EP2014/065317
(87) Internationale Veröffentlichungsnummer: WO 2016/008527

(56) Entgegenhaltungen:
- DE-A1- 3 734 494
- DE-A1-102011 004 007

## Beschreibung

Die vorliegende Erfindung betrifft ein Feldgerät mit einer Eingabeeinheit, wobei die Eingabeeinheit eine erste Anzahl von Schaltelementen zur Erzeugung von ersten Eingabesignalen und eine zweite Anzahl von den Schaltelementen zugeordneten und magnetisch betätigbaren Sensorelementen zur Erzeugung von zweiten Eingabesignalen aufweist, wobei die zweiten Eingabesignale zu den ersten Eingabesignalen logisch oder verknüpft sind.

Derartige Feldgeräte mit Eingabeeinheiten sind aus dem Stand der Technik beispielsweise aus der DE 37 34 494 bekannt, die eine explosionssichere Steueranordnung beschreibt, bei der eine Gruppe von Dateneingabe/-taststellen eine Gruppe von mit den Taststellen ausgerichteten, magnetisch betätigbaren Sensoren zugeordnet ist. Bei dieser aus dem Stand der Technik bekannten Anordnung ist jeweils einer Eingabetaste ein magnetisch betätigbarer Sensor zugeordnet und unmittelbar unterhalb dieser platziert. Wenn es nunmehr notwendig ist an der Steueranordnung, die in einem explosionssicheren Gehäuse angeordnet ist eine Eingabe zu tätigen, so kann dies mittels eines Permanentmagneten mittels dessen die magnetisch betätigbaren Sensoren aktivierbar sind, erfolgen. Ausschlaggebend bei der aus dem Stand der Technik bekannten Anordnung ist es, dass die Tasten und die den Tasten zugeordneten Sensoren einen minimalen Abstand, der dem Störabstand der Sensoren entspricht, nicht unterschreiten. Als Störabstand wird in der vorliegenden Anmeldung der Abstand zweier Sensoren, ab dem eine Unterscheidung von Eingaben zwischen zwei Sensoren nicht mehr eindeutig möglich ist verstanden.

Alternative Möglichkeiten zur Bedienung von Eingabeeinheiten von Feldgeräten aus dem Stand der Technik sind beispielsweise eine kapazitive Eingabe, wie sie beispielsweise bei modernen Smartphones und Tablett-PCs verwendet wird oder das Abscannen eines Feldes auf Infrarotstrahlung. Kapazitive Eingaben sind allerdings in der Distanz, auf die eine Bedienung erfolgen kann sehr eingeschränkt und das Abscannen von Feldern auf Infrarotstrahlung ist in eingebetteten Systemen, wie sie bei Feldgeräten typischerweise zum Einsatz kommen sehr rechenaufwendig. Beide Systeme sind daher nicht oder nur bedingt einsetzbar. Weiterhin sind Systems, welche mittels Infrarot arbeiten, aufgrund von auftretenden Verschmutzungen sehr anfällig.

Ein Feldgerät gemäß dem Oberbegriff des Anspruchs 1 ist aus DE 10 2011 004007 A1 bekannt.

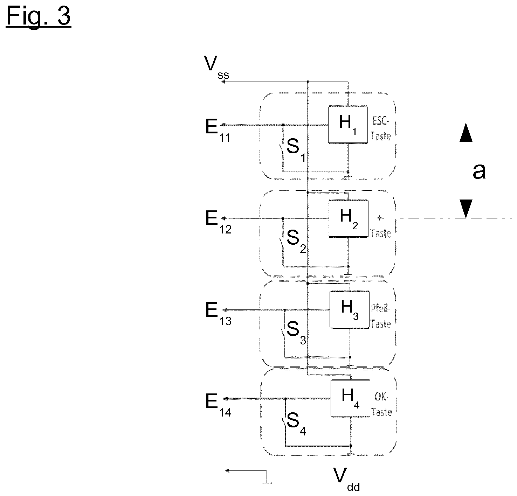

Figur 3 zeigt eine Eingabeeinheit 1 für ein Feldgerät, wie sie aus dem Stand der Technik bekannt ist. Die Eingabeeinheit 1 weist vier in einer Spalte angeordnete Schaltelemente S₁ bis S₄ auf, denen jeweils ein Sensorelement H₁ bis H₄ zugeordnet ist. Die Schaltelemente S₁ bis S₄ und die zugeordneten Sensorelemente H₁ bis H₄ sind elektrisch parallel geschaltet, so dass jeweils durch eine Betätigung eines Schaltelements S₁ bis S₄ oder des dem Schaltelement zugeordneten Sensorelements H₁ bis H₄ ein Eingabesignal E₁ bis E₄ ausgebbar ist. Beispielsweise sind das erste Schaltelement S₁ und das erste Sensorelement H₁ parallel geschaltet, so dass sowohl eine Betätigung des als Taster ausgebildeten ersten Schaltelements S₁ als auch eine Anregung des ersten Sensorelements H₁, das als erster Hallsensor ausgebildet ist, das erste Eingabesignal E₁ erzeugt. Der Einfachheit halber sind technisch notwendige Pull-Up-Widerstände für die Eingabesignale E1 bis E4 nicht dargestellt. Diese sind aber funktional erforderlich und werden vom Fachmann entsprechend vorgesehen.

Es ist die Aufgabe der vorliegenden Erfindung ein Feldgerät mit einer Eingabeeinheit derart weiterzubilden, dass eine höhere Eingabegenauigkeit erreicht wird und eine weitere Miniaturisierung der Eingabeeinheit möglich wird.

Diese Aufgabe wird durch ein Feldgerät mit den Merkmalen des Patentanspruchs 1 gelöst.

Ein erfindungsgemäßes Feldgerät mit einer Eingabeeinheit mit einer ersten Anzahl von Schaltelementen zur Erzeugung von ersten Eingabesignalen und einer zweiten Anzahl von den Schaltelementen zugeordneten, bevorzugt räumlich zugeordneten und magnetisch betätigbaren Sensorelementen zur Erzeugung von zweiten Eingabesignalen, die zu den ersten Eingabesignalen logisch oder -verknüpft sind zeichnet sich dadurch aus, dass jedem Schaltelement wenigstens zwei Sensorelemente zugeordnet sind, die derart angeordnet und verschaltet sind, dass eine Ausgabe des jeweiligen zweiten Eingabesignals nur erfolgt, wenn wenigstens zwei oder mehr vorbestimmte, einem Schaltelement zugeordnete Sensorelemente betätigt sind.

Durch die Zuordnung von wenigstens zwei Sensorelementen zu einem Schaltelement kann erreicht werden, dass der kombinierte Störabstand dieser beiden dem Schaltelement zugeordneten Sensorelemente gegenüber einer 1:1 Zuordnung, wie sie aus dem Stand der Technik bekannt ist, deutlich sinkt und damit eine weitere Miniaturisierung, d. h. insbesondere Verringerung eines Abstands zwischen zwei Schaltelementen möglich ist. Ausschlaggebend bei der vorliegenden Konfiguration ist vor allem, dass eine Bedienung über ein magnetisches Eingabegerät, beispielsweise einen Permanentmagneten dadurch intuitiver gestaltet werden kann, dass die Bedienung an den gleichen Punkten wie eine manuelle Bedienung über die Schaltelemente, die beispielsweise als mechanische Taste ausgebildet sein können, erfolgt. Es kann dadurch darauf verzichtet werden, dass für die beiden unterschiedlichen Eingabevarianten unterschiedliche Bedienfelder bereit gehalten werden müssen.

Vorzugsweise weisen die Schaltelemente und die Sensorelemente eine regelmäßige Anordnung auf, wobei die Schaltelemente und die Sensorelemente beispielsweise in Zeilen und/oder Spalten angeordnet sein können. Durch eine regelmäßige Anordnung der Schaltelemente und der Sensorelemente wird eine Zuordnung von Sensorelementen zu Schaltelementen besonders einfach und es kann außerdem eine Mehrfachnutzung einzelner Sensorelemente für beispielsweise zwei benachbart angeordnete Schaltelemente erfolgen. Vorzugsweise sind dafür bei in Zeilen angeordneten Schaltelementen ebenfalls in Zeilen angeordnete Sensorelemente vorgesehen, wobei ein Schaltelement jeweils zwischen zwei Sensorelementen angeordnet ist. Vorzugsweise sind dafür in einer Zeile mit n-Schaltelemente n+1-Sensorelemente angeordnet, wobei eine Zeile durch eine abwechselnde Anordnung von Sensorelementen und Schaltelementen gebildet ist. Die vorliegende Erfindung kann auch auf eine spaltenweise Anordnung bzw. eine matrixartige Anordnung von Schaltelementen und entsprechend zugeordneten Sensorelementen übertragen werden.

Durch eine derartige Ausgestaltung wird es ermöglicht, dass bei der Anordnung von Schaltelementen in einer Zeile jeweils zwei dem Schaltelement zugeordnete und benachbart angeordnete Sensorelemente betätigt sein müssen, damit das entsprechende zweite Eingabesignal ausgegeben wird.

Die Sensoren können hierfür beispielsweise als Hall-Sensoren ausgebildet sein, wobei auch andere Sensoren zur Detektion von Magnetfeldern entsprechend geeignet sind.

Eine übliche Ausgestaltungsform der Schaltelemente sind Taster, wobei insbesondere Folientastaturen bevorzugt zum Einsatz kommen.

Besonders vorteilhaft ist die vorliegende Erfindung, wenn wenigstens die Eingabeeinheit in einem explosionssicheren Gehäuse angeordnet ist, da oft bei dieser Anwendung die Vorteile von magnetisch betätigbaren Sensorelementen gegenüber anderen berührungslosen Eingabemöglichkeiten besonders hervortreten.

Hervorzuheben ist insbesondere die Möglichkeit über größere Distanzen, insbesondere einen Abstand von 2 mm bis 15 mm eine Bedienung durchzuführen.

Wie bereits angedeutet ist es besonders vorteilhaft, wenn ein Schaltelement eine korrespondierende Beschriftung zugeordnet ist, die auch für die zweiten Eingabesignale, die durch Betätigung der magnetisch betätigbaren Sensorelemente ausgegeben werden, gilt.

Den Schaltelementen und den zugeordneten Sensorelementen kann jeweils ein Anzeigemittel angeordnet sein, das eine Betätigung des Schaltelements und/oder der zugeordneten Sensorelemente anzeigt. Ein derartiges Anzeigeelement kann beispielsweise eine Leuchtdiode sein, die eine Betätigung des Schaftelements bzw. der zugeordneten Sensorelemente anzeigt, wenn ein entsprechendes Eingabesignal ausgegeben wird.

Diese Ausgestaltung hat den Vorteil, dass eine Bedienfreundlichkeit dadurch erzeugt werden kann, dass eine einzige Bedienoberfläche, die die einzelnen Schaltelemente kennzeichnet auch für die Auswahl der Sensorelemente H₁ bis H₄ verwendet werden kann. Des Weiteren behebt das Anzeigemittel das Fehlen der taktilen Rückwirkung bei der Bedienung über Sensorelemente. Bei Folientastaturen ist eine taktile Rückwirkung über beispielsweise einen verwendeten Knackfrosch, d. h. eine taktil rückwirkende mechanische Ausgestaltung des Testers, gegeben. Bei der Verwendung von Sensorelementen hat der Anwender nur eine Rückwirkung über ein Display. Dieses kann aber in leistungsarmen Geräten verlangsamt sein. Eine schnelle Rückwirkung ob eine Taste gedrückt wurde bekommt der Anwender über das Anzeigemittel, was zum Beispiel ein LED sein kann.

Wie bereits dargestellt ist es an der aus dem Stand der Technik bekannten Anordnung jedoch nachteilig, dass bei zunehmender Miniaturisierung der Feldgeräte und damit zur Miniaturisierung der Eingabegeräte 1 eine Verringerung eines Abstands a zwischen den Schaltelementen S₁ bis S₄ und damit auch zwischen den Sensorelementen H₁ bis H₄ notwendig ist. Bei einer derartigen Verringerung des Abstands kann aber der notwendige Störabstand zwischen den Sensorelementen H₁ bis H₄ nicht mehr eingehalten werden, so dass eine eindeutige Bedienung, d. h. eine eindeutige Erzeugung eines bestimmten Eingabesignals E₁ bis E₄ über die Sensorelemente H₁ bis H₄ nicht mehr möglich ist.

Hier setzt die vorliegende Erfindung an.

Die vorliegende Erfindung wird nachfolgend unter Bezugnahme auf die beigefügten Figuren eingehend erläutert. Es zeigen:
- Figur 1: ein erstes Ausführungsbeispiel einer Eingabeeinheit mit in einer Spalte angeordneten Schaltelementen und Sensorelementen und
- Figur 2: ein zweites Ausführungsbeispiel einer Eingabeeinheit mit matrixartig angeordneten Schaltelementen und Sensorelementen und
- Figur 3: eine Eingabeeinheit gemäß dem Stand der Technik (schon behandelt).

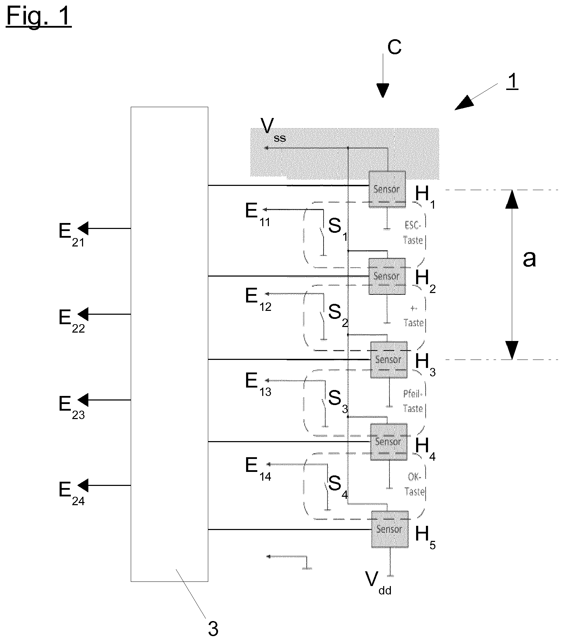

Figur 1 zeigt ein erstes Ausführungsbeispiel einer erfindungsgemäßen Eingabeeinheit 1, wobei in dem dargestellten Ausführungsbeispiel eine Anzahl von vier Schaltelementen S₁ bis S₄ in einer Spalte C angeordnet sind. Die Positionen der Schaltelemente S₁ bis S₄, die vorliegend als mechanische Taste ausgestaltet sind, repräsentieren auch die Position von den Schaltelementen S₁ bis S₄ zugeordneten Tasten, die in Figur 1 schematisch dargestellt sind. Die Schaltelemente S₁ bis S₄ geben jeweils erste Eingabesignale E₁₁ bis E₁₄ bei deren Betätigung aus. In der Spalte C sind außerdem Sensorelemente H₁ bis H₅ angeordnet, wobei ein Schaltelement S₁ bis S₄ jeweils zwischen zwei Sensorelementen H₁ bis H₅ angeordnet ist. Beispielsweise ist ein erstes Schaltelement S₁ zwischen einem ersten Sensorelement H₁ und einem zweiten Sensorelement H₂ angeordnet. Ein zweites Schaltelement S₂ ist entsprechend zwischen dem zweiten Sensorelement H₂ und einem dritten Sensorelement H₃ angeordnet usw.. Um nun die gewünschte Redundanz in der Bedienung herzustellen, d. h. entweder eine manuelle Bedienung über die Schaltelemente S₁ bis S₄ oder eine Bedienung über ein magnetisches Eingabegerät, beispielsweise einen Permanentmagneten und die Sensorelemente H₁ bis H₅ zu ermöglichen und entsprechende zweite Eingabesignale E₂₁ bis E₂₄ bei einer Bedienung über das Eingabegerät zu erreichen sind die Sensorelemente H₁ bis H₅ derart miteinander verknüpft, dass ein entsprechendes zweites Eingabesignal nur bei einer Betätigung von beiden einem Schaltelement S₁ bis S₄ zugeordneten Sensorelementen H₁ bis H₅ ausgegeben wird. Beispielsweise wird das zweite Eingabesignal E₂₁, das zu dem ersten Eingabesignal E₁₁ des ersten Schaltelements S₁ korrespondiert nur ausgegeben, wenn das erste Sensorelement H₁ und das zweite Sensorelement H₂ beide betätigt werden. Da eine Betätigung beider Sensorelemente H₁ und H₂ notwendig ist, ist als Störabstand zwischen den den jeweiligen Schaltelementen zugeordneten Sensorelementen nicht mehr der Abstand zwischen zwei benachbarten Sensorelementen H₁, H₂ sondern der Abstand zum jeweils übernächsten Sensorelement relevant. Auf diese Weise kann eine weitere Miniaturisierung der Eingabeeinheit 1 erfolgen und gleichzeitig eine Verbesserung der Detektion bei einer Bedienung über einen Permanentmagneten erreicht werden.

Für die Ausgabe der zweiten Eingabesignale bzw. die Verknüpfung der Sensorelemente H₁ bis H₅ ist eine Logikeinheit 3 vorgesehen.

Das in Figur 1 dargestellte Ausführungsbeispiel kann selbstverständlich mit mehr oder weniger Schaltelementen und mehr oder weniger Sensorelementen ausgestaltet sein. Einer Anzahl von n-Schaltelementen in einer Spalte C ist in diesem Fall jeweils eine zweite Anzahl von wenigstens n+1-Sensorelelementen zugeordnet.

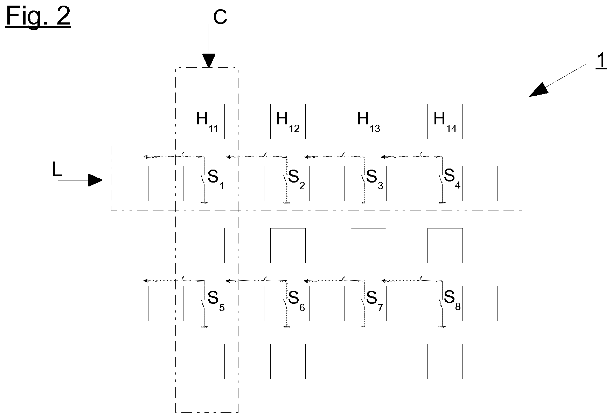

Figur 2 zeigt ein weiteres Ausführungsbeispiel einer Eingabeeinheit 1, wobei in dem in Figur 2 dargestellten Ausführungsbeispiel die Schaltelemente S in vier Spalten und zwei Zeilen matrixartig angeordnet sind. Um in dieser Ausgestaltungsform eine optimale Miniaturisierung zu erreichen ist es vorteilhaft, wenn in jeder Spalte C mit n-Schaltelementen, vorliegend zwei, n+1-Sensorelemente, vorliegend drei Sensorelemente vorgesehen sind. Dementsprechend sind in jeder Zeile L mit n-Schaltelementen, vorliegend vier, n+1-Sensorelemente, vorliegend fünf, vorgesehen. Im vorliegenden Ausführungsbeispiel ergibt sich damit eine matrixartige Anordnung von insgesamt acht Schaltelementen, denen 22 Sensorelemente zugeordnet sind.

Die Zahl der notwendigen Sensorelemente kann je nach Ausführungsform durch geschickte Anordnung der Sensorelemente relativ zu den Schaltelementen optimiert werden, wobei im Schaltelement nach wie vor wenigstens zwei Sensorelemente zugeordnet bleiben.

### Bezugszeichenliste

- 1: Eingabeeinheit
- 3: Logikeinheit
- S₁ bis S₄: Schaltelemente
- H₁ bis H₄: Sensorelemente
- E₁₁ bis E₁₄: erste Eingabesignale
- E₂₁ bis E₂₄: zweite Eingabesignale
- L: Zeilen
- C: Spalten

## Patentansprüche

1. Feldgerät mit einer Eingabeeinheit (1) mit einer ersten Anzahl von Schaltelementen (S₁ bis S_{4;} S₁ bis S₈) zur Erzeugung von ersten Eingabesignalen (E₁₁ bis E₁₄) und einer zweiten Anzahl von den Schaltelementen (S₁ bis S₄; S₁ bis S₈) zugeordneten und magnetisch betätigbare Sensorelementen (H₁ bis H₅) zur Erzeugung von zweiten Eingabesignalen (E₂₁ bis E₂₄), **dadurch gekennzeichnet, dass** die zweiten Eingabesignale zu den ersten Eingabesignalen (E₁₁ bis E₁₄) logisch oder -verknüpft sind,
wobei jedem Schaltelement (S₁ bis S₄; S₁ bis S₈) wenigstens zwei Sensorelemente (H₁ bis H₅; H₁₁ bis H₃₂) zugeordnet sind, die derart angeordnet und verschaltet sind, dass eine Ausgabe des jeweiligen zweiten Eingabesignals (E₂₁ bis E₂₄) nur erfolgt, wenn wenigstens zwei vorbestimmte, einem Schaltelement (S₁) zugeordnete Sensorelemente (H₁ bis H₅; H₁₁ bis H₃₂) betätigt sind.

2. Feldgerät nach Anspruch 1,
**dadurch gekennzeichnet, dass**
die Schaltelemente (S₁ bis S₄; S₁ bis S₈) und die Sensorelemente (H₁ bis H₄; H₁₁ bis H₃₂) eine regelmäßige Anordnung aufweisen.

3. Feldgerät nach Anspruch 2,
**dadurch gekennzeichnet, dass**
die Schaltelemente (S₁ bis S₄; S₁ bis S₈) und die Sensorelemente (H₁ bis H₅; H₁₁ bis H₃₂) in Zeilen (L) und/oder Spalten (C) angeordnet sind.

4. Feldgerät nach Anspruch 3,
**dadurch gekennzeichnet, dass** jeweils ein Schaltelement (S₁ bis S₄; S₁ bis S₈) zwischen jeweils wenigstens zwei ihm zugeordneten Sensorelementen (H₁ bis H₅; H₁₁ bis H₃₂) angeordnet ist.

5. Feldgerät nach Anspruch 4,
**dadurch gekennzeichnet, dass**
pro Zeile (L) und/oder Spalte (C) jeweils n Schaltelemente (S₁ bis S₄; S₁ bis S₈) und n+1 Sensorelemente (H₁ bis H₅; H₁₁ bis H₃₂) angeordnet sind.

6. Feldgerät nach einem der vorhergehenden Ansprüche,
**dadurch gekennzeichnet, dass**
die Sensorelemente (H₁ bis H₅; H₁₁ bis H₃₂) als Hall-Sensoren ausgebildet sind.

7. Feldgerät nach einem der vorhergehenden Ansprüche,
**dadurch gekennzeichnet, dass**
die Schaltelemente (S₁ bis S₄; S₁ bis S₈) als Taster, insbesondere als Folientastatur ausgebildet sind.

8. Feldgerät nach einem der vorhergehenden Ansprüche,
**dadurch gekennzeichnet, dass** wenigstens die Eingabeeinheit (1) in einem explosionssicheren Gehäuse angeordnet ist.

9. Feldgerät nach einem der vorhergehenden Ansprüche,
**dadurch gekennzeichnet, dass**
dass den Schaltelementen (S₁ bis S₄; S₁ bis S₈) eine korrespondierende Beschriftung zugeordnet ist.

10. Feldgerät nach einem der vorhergehenden Ansprüche,
**dadurch gekennzeichnet, dass**
den Schaltelementen (S₁ bis S₄; S₁ bis S₈) und den zugeordneten Sensorelementen (H₁ bis H₅; H₁₁ bis H₃₂) wenigstens ein Anzeigemittel zugeordnet ist, das eine Betätigung des Schaltelements (S₁ bis S₄; S₁ bis S₈) und/oder der zugeordneten Sensorelemente (H₁ bis H₄; H₁₁ bis H₃₂) anzeigt.

## Claims

1. Field device with an input unit (1) comprising a first number of switching elements (S₁ to S₄; S₁ to S₈) to generate first input signals (E₁₁ to E₁₄) and a second number of sensor elements (H₁ to H₅) which are associated with the switching elements (S₁ to S₄; S₁ to S₈) and can be magnetically actuated, in order to generate second input signals (E₂₁ to E₂₄), **characterised in that** the second input signals are logically OR-linked to the first input signals (S₁ to S₄; S₁ to S₈), wherein at least two sensor elements (H₁ to H₅; H₁₁ to H₃₂) associated with each switching element (S₁ to S₄; S₁ to S₈) are arranged and switched in such a way that an output of the respective second input signal (E₂₁ to E₂₄) occurs only if at least two predetermined sensor elements (H₁ to H₅; H₁₁ to H₃₂) associated with a switching element (S₁) are actuated.

2. Field device according to claim 1, **characterised in that** the switching elements (S₁ to S₄; S₁ to S₈) and the sensor elements (H₁ to H₄; H₁₁ to H₃₂) have a regular arrangement.

3. Field device according to claim 2, **characterised in that** the switching elements (S₁ to S₄; S₁ to S₈) and the sensor elements (H₁ to H₅; H₁₁ to H₃₂) are arranged in lines (L) and/or columns (C).

4. Field device according to claim 3, **characterised in that** in each case one switching element (S₁ to S₄; S₁ to S₈) is arranged between at least two sensor elements (H₁ to H₅; H₁₁ to H₃₂) associated therewith.

5. Field device according to claim 4, **characterised in that** in each case n switching elements (S₁ to S₄; S₁ to S₈) and n+1 sensor elements (H₁ to H₅; H₁₁ to H₃₂) are arranged per line (L) and/or column (C).

6. Field device according to one of the preceding claims, **characterised in that** the sensor elements (H₁ to H₅; H₁₁ to H₃₂) are designed as Hall effect sensors.

7. Field device according to one of the preceding claims, **characterised in that** the switching elements (S₁ to S₄; S₁ to S₈) are designed as keys, particularly as a membrane keyboard.

8. Field device according to one of the preceding claims, **characterised in that** at least the input unit (1) is arranged in a housing which is protected against explosion.

9. Field device according to one of the preceding claims, **characterised in that** a corresponding inscription is associated with the switching elements (S₁ to S₄; S₁ to S₈).

10. Field device according to one of the preceding claims, **characterised in that** at least one display means is associated with the switching elements (S₁ to S₄; S₁ to S₈) and the associated sensor elements (H₁ to H₅; H₁₁ to H₃₂), and indicates the actuation of the switching element (S₁ to S₄; S₁ to S₈) and/or the associated sensor elements (H₁ to H₄; H₁₁ to H₃₂).

## Revendications

1. Appareil de chantier comprenant une unité d'entrée (1) comportant une première série d'éléments de commutation (S₁ à S₄, S₁ à S₈) permettant d'obtenir des premiers signaux d'entrée (E₁₁ à E₁₄) et à une seconde série d'éléments de capteur à actionnement magnétique (H₁ à H₅) associés aux éléments de commutation (S₁ à S₄; S₁ à S₈) et permettant d'obtenir des seconds signaux d'entrée (E₂₁ à E₂₄),
**caractérisé en ce que**
les seconds signaux d'entrée sont combinés par une fonction logique aux premiers signaux d'entrée (E₁₁ à E₁₄), à chaque élément de commutation (S₁ à S₄; S₁ à S₈) étant associés au moins deux éléments de capteur (H₁ à H₅ ; H₁₁ à H₂₂) qui sont positionnés et branchés de sorte qu'une délivrance en sortie du second signal d'entrée respectif (E₂₁ à E₂₄) ne se produise que lorsqu'au moins deux éléments de capteur (H₁ à H₅ ; H₁₁ à H₃₂) prédéfinis associés à un élément de commutation (S₁) sont actionnés.

2. Appareil de chantier conforme à la revendication 1,
**caractérisé en ce que**
les éléments de commutation (S₁ à S₄; S₁ à S₈) et les éléments de capteur (H₁ à H₄ ; H₁₁ à H₃₂) sont disposés régulièrement.

3. Appareil de chantier conforme à la revendication 2,
**caractérisé en ce que**
les éléments de commutation (S₁ à S₄; S₁ à S₈) et les éléments de capteur (H₁ à H₅ ; H₁₁ à H₃₂) sont disposés en lignes (L) et/ou en colonnes (C).

4. Appareil de chantier conforme à la revendication 3,
**caractérisé en ce qu'**
un élément de commutation (S₁ à S₄; S₁ à S₈) est respectivement monté entre au moins deux éléments de capteur (H₁ à H₅ ; H₁₁ à H₃₂) respectifs qui lui sont associés.

5. Appareil de chantier conforme à la revendication 4,
**caractérisé en ce que**
sur chaque ligne (L) et/ou chaque colonne (C) sont respectivement montés n éléments de commutation (S₁ à S₄; S₁ à S₈) et n+1 éléments de capteur (H₁ à H₅ ; H₁₁ à H₃₂).

6. Appareil de chantier conforme à l'une des revendications précédentes,
**caractérisé en ce que**
les éléments de capteur (H₁ à H₅ ; H₁₁ à H₃₂) sont réalisés sous la forme de capteurs à effet Hall.

7. Appareil de chantier conforme à l'une des revendications précédentes,
**caractérisé en ce que**
les éléments de commutation (S₁ à S₄; S₁ à S₈) sont réalisés sous la forme de touches, en particulier d'un écran à touches.

8. Appareil de chantier conforme à l'une des revendications précédentes,
**caractérisé en ce qu'**
au moins l'unité d'entrée (1) est montée dans un boîtier anti-explosion.

9. Appareil de chantier conforme à l'une des revendications précédentes,
**caractérisé en ce qu'**
aux éléments de commutation (S₁ à S₄; S₁ à S₈) est respectivement associée une légende correspondante.

10. Appareil de chantier conforme à l'une des revendications précédentes,
**caractérisé en ce qu'**
aux éléments de commutation (S₁ à S₄; S₁ à S₈) et aux éléments de capteur associés (H₁ à H₅ ; H₁₁ à H₃₂) est associé au moins un moyen d'affichage qui affiche un actionnement de l'élément de commutation (S₁ à S₄; S₁ à S₈) et/ou des éléments de capteur associés (H₁ à H₄ ; H₁₁ à H₃₂).
